# EUROPEAN PATENT SPECIFICATION

(11) **EP 1 259 102 B1**
(45) Date of publication and mention of the grant of the patent: **09.01.2008**
(21) Application number: 01111661.3
(22) Date of filing: 14.05.2001
(51) Int. Cl.: H05K 3/46

(54) **Multi-layer printed circuit bare board enabling higher density wiring and a method of manufacturing the same**
Unbestückte mehrschichtige Leiterplatte zum ermöglichen einer höheren Verdrahtungsdichte und Verfahren zu deren Herstellung
Panneau nu à circuit imprimé multicouche permettant une plus haute densité de câblage et son procédé de fabrication

(43) Date of publication of application: 20.11.2002
(73) Proprietor: OKI PRINTED CIRCUITS CO., LTD., Joetsu-shi, Niigata (JP)
(72) Inventor: Iinaga, Hiroshi, Joetsu-shi, Niigata (JP)
(74) Representative: Weser, Wolfgang

(56) References cited:
- DE-A- 3 605 474
- US-A- 5 218 761
- US-A- 5 758 413
- US-A- 6 037 547
- PATENT ABSTRACTS OF JAPAN vol. 1996, no. 08, 30 August 1996 (1996-08-30) -& JP 08 107280 A (OKI ELECTRIC IND CO LTD), 23 April 1996 (1996-04-23)
- VENKAT S: "LASER DRILLED MICROVIAS PRESENT AND FUTURE LASER DRILLING PROMISES EVEN FASTER, MORE FLEXIBLE AND ECONOMICAL MICROVIA MANUFACTURING IN THE FUTURE" CIRCUITREE, CIRCUITREE PUB., SANTA CLARA, CA,, US, vol. 13, no. 10, October 2000 (2000-10), page 10,12,14,16,18 XP001023572 ISSN: 1059-843X
- PATENT ABSTRACTS OF JAPAN vol. 017, no. 476 (E-1424), 30 August 1993 (1993-08-30) & JP 05 114788 A (FUJITSU LTD), 7 May 1993 (1993-05-07)
- PATENT ABSTRACTS OF JAPAN vol. 1995, no. 02, 31 March 1995 (1995-03-31) & JP 06 310867 A (MATSUSHITA ELECTRIC WORKS LTD), 4 November 1994 (1994-11-04)
- PATENT ABSTRACTS OF JAPAN vol. 1999, no. 03, 31 March 1999 (1999-03-31) & JP 10 335828 A (NIPPON CARBIDE IND CO INC), 18 December 1998 (1998-12-18)
- PATENT ABSTRACTS OF JAPAN vol. 1998, no. 01, 30 January 1998 (1998-01-30) & JP 09 246724 A (HITACHI CHEM CO LTD), 19 September 1997 (1997-09-19)
- PATENT ABSTRACTS OF JAPAN vol. 013, no. 312 (E-788), 17 July 1989 (1989-07-17) & JP 01 084786 A (NEC CORP), 30 March 1989 (1989-03-30)
- PATENT ABSTRACTS OF JAPAN vol. 2000, no. 08, 6 October 2000 (2000-10-06) & JP 2000 151111 A (TOPPAN PRINTING CO LTD), 30 May 2000 (2000-05-30)
- PATENT ABSTRACTS OF JAPAN vol. 018, no. 326 (E-1565), 21 June 1994 (1994-06-21) & JP 06 077662 A (HITACHI LTD), 18 March 1994 (1994-03-18)

## Description

### BACKGROUND OF THE INVENTION

### Field of the Invention

The present invention relates to a multi-layer printed circuit bare board, and more particularly to such a board which enables higher density wiring, and also a method of manufacturing the same.

### Description of the Background Art

A further quest for higher wiring density is requested in printed circuit bare boards along with the trend of higher function and higher density interconnection of electronic equipment. Multi-layer printed circuit bare boards have been put to use in order to meet the request, see for example JP-A-08107280, US-A-5 218 761 and DE-A-36 05 474. Multi-layer printed circuit bare boards, it is getting difficult to draw out signal lines from BGA terminals using via holes, because via holes leave less space for wiring. In order to overcome the problem, a built-up structure of multi-layer printed boards may be used which can have smaller via holes and fewer through holes than conventional multi-layer boards. Built-up multi-layer printed circuit bare boards are manufactured in a "build-up" method, with which a conductive layer is formed over another conductive layer subsequently, so that the more layers require the more process steps. For example, at least the following process steps would be needed to make built-up boards; 1) a surface treatment process to increase adhesion between resin and conductive material, 2) applying insulation material (resin) over a conductive layer, 3) cure of the resin, 4) lasering (hole-making), 5) removing resin smear, 6) electroless copper deposition, 7) electrical copper plating, 8) photo-imaging and copper-etching, and 9) cure of the resin.

Built-up multi-layer printed circuit bare boards confronted some difficulty with BGA packaging when a via hole is wanted under a solder bump foot since the via hole is not filled sufficiently so that some amount of solder is taken in the via hole leaving insufficient amount of solder for joint. This problem forced putting connection lands between the solder bump lands, which placed a limitation to higher wiring density of the printed bare boards.

Moreover, with the conventional multi-layer built-up printed circuit boards, when the surface, or first, layer is required to be connected to the fourth layer from the surface, the process includes 27 process steps, which are three times as many as the above-mentioned process steps 1)-9), which has increased the manufacturing cost of built-up multi-layer boards.

In addition, with the manufacturing process of a conventional built-up structure of multi-layer printed circuit bare boards as described above, the interconnection between the first and fourth layers requires the boards to be subject to a resin cure process up-to three times, which may generate excessive heat to cause warp in the resin, resulting in a dimensional inaccuracy.

US 5,758,413 discloses a method of manufacturing a multiple layer circuit board die carrier with fine dimension stacked vias. JP-A-06310867 discloses a multilayered printing wiring board, its manufacture, and a semiconductor device using a multilayered printed wiring board.

### SUMMARY OF THE INVENTION

It is an object of the present invention to give a solution to these problems, more specifically to provide a multi-layer printed circuit bare board, and a method of manufacturing the same, in which a connection is established between conductive layers with another conductive layer intervening in between with better dimensional accuracy and fewer process steps than those of conventional built-up multi-layer printed circuit bare boards.

These objects are achieved by the multi-layer printed circuits bare board according to claim 1 and the method for manufacturing a multi-layer printed circuit bare board according to claim 11. The other claims relate to further developments.

In accordance with the present invention, a multi-layer printed circuit bare board, which has 2n circuit layers, where n is a natural number exceeding a unity, includes electrical connections established between the (2i-1)-th layer and the 2i-th layer, where i=1, 2,....,n, by holes which are created through insulation material layers in between and filled with copper plating. Electrical connections are also accomplished between the 4i-th layer and the (4i-3)-th layer by holes created through insulation material layers in between and filled with copper plating.

In accordance with the present invention, a multi-layer printed circuit bare board comprises: at least two insulative layers each having two generally flat, primary surfaces; circuit layers including electrically conductive material forming electric circuitry and carried on at least one of the primary surfaces of said insulative layers; and bonding layers of insulative material intervening between adjacent ones of said insulative layers and bonding said adjacent insulative layers with each other to accumulate said circuit layers with one above the other; at least one of said insulative layers having a first through hole open to the primary surfaces thereof and filled with electrically conductive material interconnecting the circuit layers carried thereon with each other.

In an aspect of the invention, said electrically conductive material may advantageously be of copper plating.

Further in an aspect of the invention, said first through hole may preferably have a diameter of 40 micro-meter or less.

Advantageously in accordance with the present invention, one of said insulative layers and one of said bonding layers which is bonded to said first insulative layer have a second through hole cut therethrough to extend to the primary surface of second one of said insulative layers which is bonded to said one bonding layer, said second through hole being filled with electrically conductive material interconnecting the circuit layers carried on said first and second insulative layers with each other.

In accordance with the present invention, a multi-layer printed circuit bare board comprises: 2n circuit layers having electrically conductive material forming electric circuitry, where n is a natural number exceeding a unity; *n* insulative layers having two primary surfaces on which (2i-1)-th and 2i-th ones of said circuit layers are carried, where *i* is a natural number not exceeding *n*; and n-1 bonding layers of insulative material intervening between adjacent ones of said n insulative layers and bonding said adjacent insulative layers with each other to accumulate said circuit layers with one above the other; the insulative layers between the (2i-1)-th and 2i-th circuit layers having a first through hole open to the primary surfaces thereof and filled with electrically conductive material interconnecting the (2i-1)-th and 2i-th circuit layers with each other.

Further in accordance with the present invention, a method of manufacturing a multi-layer printed circuit bare board comprises the steps of: preparing n sheets of insulative material, where n is a natural number exceeding a unity; making first holes through the sheets of insulative material for interconnecting (2i-1)-th and 2i-th circuit layers to be respectively carried on two primary surfaces of the sheets of insulative material, where *i* is a natural number not exceeding *n*; depositing electrically conductive material inside the first holes using an electrical plating process until the holes are filled with the conductive material; forming an electrically conductive pattern of the (2i-1)-th and 2i-th circuits on the sheet of insulative material; stacking the sheets of insulative material having the electrically conductive pattern formed one above the other and adhering adjacent ones of the sheets with each other by using bonding material; making second holes through (2i-1)-th and (2i+1)-th circuit layers; and depositing electrically conductive material inside the second holes using an electrical plating process.

### BRIEF DESCRIPTION OF THE DRAWINGS

The objects and features of the present invention will become more apparent from consideration of the following detailed description taken in conjunction with the accompanying drawings in which:
FIG. 1 is a schematic cross sectional view showing a preferred embodiment of the multi-layer printed circuit bare board in accordance with the present invention; and
FIGS. 2A and 2B show exemplified shapes of holes cut through an insulation material of the embodiment shown in FIG.1.

### DESCRIPTION OF THE PREFERRED EMBODIMENT

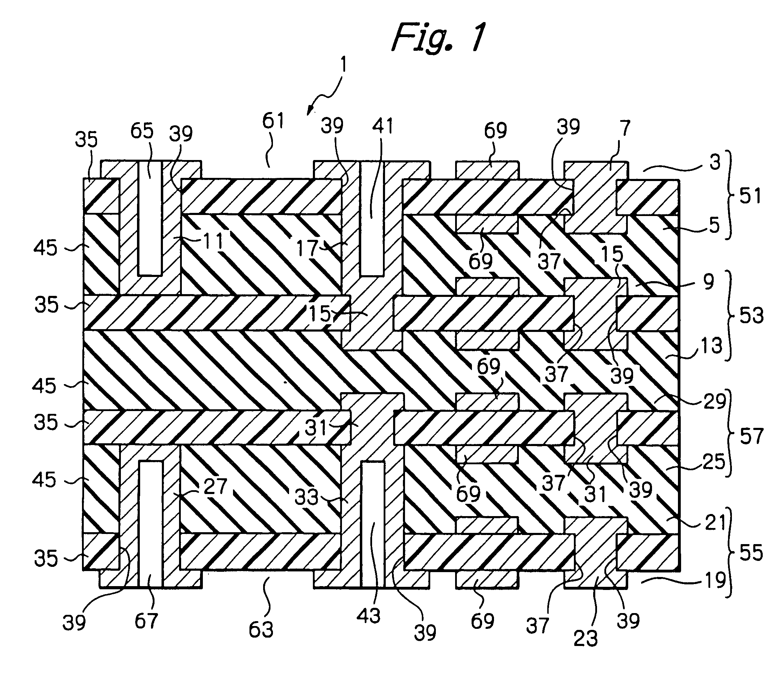

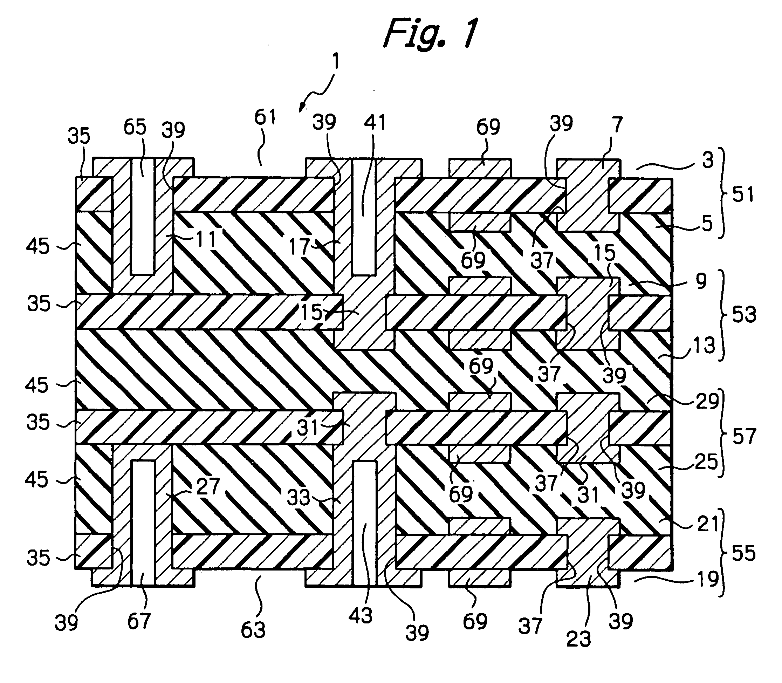

With reference to FIG. 1, a multi-layer printed circuit bare board (MLB), generally denoted with a reference numeral 1, in accordance with a preferred embodiment of the present invention has 2n multiple layers 3, 5, 9, 13, 29, 25, 21 and 19, where n is a natural number exceeding a unity (1), which form electric circuitry. Themulti-layerprintedcircuitbareboard 1 has a generally rectangular plan view with a couple of generally flat, primary surfaces 61 and 63. FIG. 1 shows a cross section substantially perpendicular to the primary surfaces 61 and 63. The specific layer structure shown in FIG. 1 includes eight layers, i.e. n is 4. The invention is not restricted to the specific illustrative embodiment but applicable to a generic case comprising 2n circuit layers. In addition, the invention is also applicable to a multi-layered structure of printed circuit bare board which has even an odd number of circuit layers such as layers 3 and 5 accumulated one above the other.

The multiple layers 3, 5, 9, 13, 29, 25, 21 and 19 are formed on the primary surfaces of electrically insulative material layers 35 to establish electro-conductive wiring 69 forming circuit patterns. The first layer 3 from the top in the figure is interconnected to the second layer 5 by a connector 7, and also to the third layer 9 by a connector 11. Likewise, the fourth layer 13 is interconnected to the third layer 9 by a connector 15, and also to the first layer 3 by a connector 17. In the same way, the 4n-th, or lowest, layer 19 is interconnected to the (4n-1)-th layer 21 by a connector 23, and also to the (4n-2)-th layer 25 by a connector 27. The (4n-3)-th layer 29 is interconnected to the (4n-2)-th layer 25 by a connector 31, and also to the 4n-th layer 19 by a connector 33.

Holes 37, which are preferably 40 micrometer or less in diameter, are created through, and substantially perpendicularly to, insulative material layers 35 between the first layer 3 and the second layer 5, between the third layer 9 and the fourth layer 13, between the 4n-th layer 19 and the (4n-1)-th layer 21, and between the (4n-2)-th layer 25 and the (4n-3)-th layer 29. The diameter of the holes 37 is 40 micrometer or less, more preferably 25-30 micrometer, and preferably not less than 15 micrometer. Those holes 37 are filled with copper plating 39, making connection from the first layer 3 to the second layer 5, from the third layer 9 to the fourth layer 13, from the 4n-th layer 19 to the (4n-1)-th layer 21, and from the (4n-2)-th layer 25 to the (4n-3)-th layer 29.

A hole 41 is also cut from the first layer 3 through an insulative, bonding layer 45 to extend to the connector 15, which is a copper-filled via formed on the third layer 9, and another hole 43 is cut from the 4n-th layer 19 through another insulative, bonding layer 45 to extend to the connector 31, which is also a copper-filled via on the (4n-2)-th layer 25. The holes 41 and 43 are plated with copper plating 39, making electrical connections from the first layer 3 to the fourth layer 13 and from the 4n-th layer 19 to the (4n-3)-th layer 29, respectively.

Holes 65 and 67 are also cut from the first and 4n-th layers 3 and 19 through the insulative, bonding layers 45 to reach the third and (4n-2)-th layers 9 and 25, respectively, as shown in the figure. The holes 65 and 67 are also plated with copper plating 39, making electrical connections from the first layer 3 to the third layer 9 and from the 4n-th layer 19 to the (4n-2)-th layer 25, respectively.

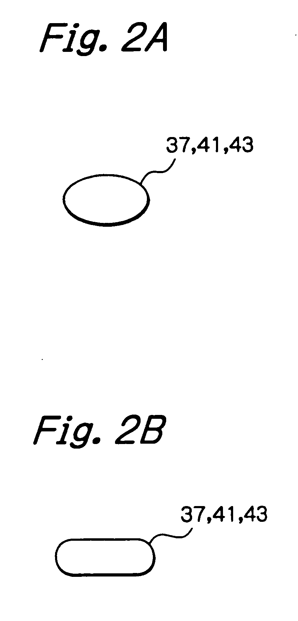

Those holes 37, 41, 43, 65 and 67 may advantageously be of a circular cross section perpendicular to the primary surfaces of the insulative material sheets 35. The invention is not restricted to this particular cross-sectional shape of the holes but may also be applicable to the oval shape shown in FIG. 2A, and also to cylindrical through holes which have a cross-section perpendicular to the longitudinal axis thereof and formed by a couple of opposing sectors interconnected to each other by straight lines.

The insulation material layers 35 may advantageously be made of either of glass epoxy, glass BT, glass polyimide, polyimide film, epoxy film, epoxy impregnated liquid crystal polymer fiber cloth, BT impregnated liquid crystal polymer fiber cloth, for example. Conductive material for wiring circuits 39 may be of copper or other metal.

A laser or drilling method would be favored to make holes 37 for the connections from the first layer 3 to the second layer 5, from the third layer 9 to the fourth layer 13, from the 4n-th layer 19 to the (4n-1)-th layer 21, and from the (4n-2)-th layer 25 to the (4n-3)-th layer 29. The size of the holes 37 would be favored to be 40 micrometer or less in diameter considering the wiring space and the copper filling process. On the other hand, the electric conductivity of the 40-micrometer in diameter holes 37 might be higher than the other part of the circuitry, though it is desirable to have similar conductivity throughout the circuitry. In order to achieve this, the holes 37 may have an oval or elliptical shape as illustrated in FIGS. 2A and 2B, such that the area of the holes 37 may be increased with the dimension in a particular direction maintained to be 40 micrometer or less. As a result, the conductivity of the copper-filled vias may be adjusted to be substantially equal to that of the remaining portions of the circuitry, without enlarging the dimension of the holes 37 in a desired direction. That is also the case with the remaining holes 41, 43, 65 and 67.

In order to deposit conductive material inside the holes 37, 41, 43, 65 and 67, Pd, carbon, or polymer with electro-conductive particles dispersed therein may advantageously be deposited by using an absorption method. Electroless copper plating may follow this. Instead of an absorption method, a vapor deposition method may be used to form thinner conductive film inside the holes.

An electrical plating method that is used for the manufacturing of conventional printed circuit boards may be used for the plating of the holes 37, 41, 43, 65 and 67. In such cases, the plating thickness of 20 micrometer or more would advantageously fill the holes 37, 41, 43, 65 and 67. An electroless plating method may be used instead. A negative image pattern of the circuit may be formed on the insulation material 35, so that the via filling plating and the pattern plating may be done simultaneously.

In some application, the hole 65 may be extended and interconnected to the fifth layer 29 with or without being connected to the third and/or fourth layers 9 and/or 13. Such a hole may also be interconnected to a connector, such as 31, formed in the insulating layer 35.

The conductive patterns of electronics or circuitry 69 are formed on the insulating layers 35 by using a subtractive method, with which an etching mask is formed over the copper foil that is laminated on the insulation material 35 on the side where the desired conductive pattern 69 is to be formed, and then unwanted portions of the copper foil is etched way. Either of a liquid, film, or electro-deposited type of material may be used as the etching resist.

The insulation materials 35 which have a desired copper circuit pattern formed thereon are registered with each other to be laminated or stacked with each other by using the bonding or adhesive material layer 45. More specifically, multi-layer structures 51, 53, 55 and 57 that consist of the first layer 3 and the second layer 5, the third layer 9 and the fourth layer 13, the 4n-th layer 19 and the (4n-1)-th layer 21, and the (4n-2)-th layer 25 and the (4n-3)-th layer 29, respectively, are accumulated in this order and laminated with each other with the bonding material 45 intervening to form the multi-layer printed circuit bare board 1 consequently.

A laser method may favorably be used for forming the holes on the resultant printed circuit bare board 1. Either of carbon dioxide gas, YAG (yttrium aluminum garnet), UV (ultra-violet)-YAG, or excimer laser may advantageously be applicable.

A detailed description on the manufacturing process steps of the multi-layer printed circuit bare board 1 shall follow. First of all, the cylindrical through holes 37 are created through the insulation material layers 35 in order to make connection from the first layer 3 to the second layer 5, from the third layer 9 to the fourth layer 13, from the 4n-th layer 19 to the (4n-1)-th layer 21, and from the (4n-2)-th layer 25 to the (4n-3)-th layer 29.

Then, conductive material is deposited inside the holes 37, and copper 39 for example is electrically plated until the holes are filled. Successively, conductive circuit patterns are formed on the insulation material layers 35.

The multi-layer structures 51, 53, 55 and 57 that consist of the first layer 3 and the second layer 5, the third layer 9 and the fourth layer 13, the 4n-th layer 19 and the (4n-1)-th layer 21, and the (4n-2)-th layer 25 and the (4n-3)-th layer 29, respectively, are stacked and adhered with each other by using bonding material 45 into a laminated structure.

After that, the holes 41 and 43 are created from the first layer 3 to the third layer 9, and from the 4n-th layer 19 to the (4n-2)-th layer 25. Conductive material is deposited inside the holes 41 and 43 that come through the first layer 3 to the third layer 9 and through the 4n-th layer 19 to the (4n-2)-th layer 25, respectively, to establish the electrical copper plating 39, so that the bare board 1 is finally formed. If necessary, an additional layer of conductive pattern may be formed over the most outer layers 3 and 19, for example.

With the multi-layer printed circuit bare board 1, which has as 4n layers, the holes 37 are created through the insulation material 35 between the first layer 3 and the second layer 5, between the third layer 9 and the fourth layer 13, the 4n-th layer 19 and the (4n-1)-th layer 21, and between the (4n-2)-th layer 25 and the (4n-3)-th layer, 29 respectively, and are filled with the copper plating 39, making connections between the first layer 3 and the second layer 5, between the third layer 9 and the fourth layer 13, the 4n-th layer 19 and the (4n-1)-th layer 21, and between the (4n-2)-th layer 25 and the (4n-3)-th layer 29, respectively. The connections can therefore be accomplished separately for each of the multi-layer structures 51, 53, 55 and 57 by making the holes 37 and the copper plating 39 between the first layer 3 and the second layer 5, between the third layer 9 and the fourth layer 13, between the 4n-th layer 19 and the (4n-1)-th layer 21, and between the (4n-2)-th layer 25 and the (4n-3)-th layer 29, respectively. After that, those multi-layer structures 51, 53, 55 and 57 with the connections thus established will be accumulated with each other to enable further connections between the intended layers.

Making the hole 41 from the first layer 3 to the copper-filled via 15 on the third layer 9 and the hole 43 from the 4n-th layer 19 to the copper-filled via on the (4n-2)-th layer 25, and plating the holes 41 and 43 with the copper 39 enable the connections from the first layer 3 to the fourth layer 13 and from the 4n-th layer 19 to the (4n-3)-th layer 29, such that the interconnections through the laminated multi-layer structures 51, 53, 57 and 55 can be achieved between the intended layers with the fewer manufacturing process steps.

### EXAMPLE

A detailed description will be made on an example where some multi-layer printed circuit bare boards of the structure in accordance with the invention were manufactured together with the result of the performance tests.

The holes of 25 micrometer in diameter were created through a copper-clad laminate (marketed from Matsushita Denko Kabushiki Kaisha, model R-1705: laminate thickness 0.06mm, copper foil thickness 12 micrometer) using UV-YAG laser. After the laminates were processed through Pd catalyst solution, electroless copper plating was done. Then electrical copper plating was done until copper is deposited up-to 20 micrometer over the surface to fill the via holes.

A photoresist (marketed from Asahi Chemical Industry Co., Ltd., model AQ-2588) was laminated over the surface of the laminates, and an etching mask was formed through an exposure and development process. Then the unmasked portions of the copper foil were etched off through a cupric oxide solution to get 40-micrometer width and spacing copper circuit patterns.

The laminates on which the copper circuit patterns were formed were stacked up with sheets of bonding material intervening between them, registered in respect to circuit images, and thereafter the materials were press-laminated to make the 8-layered structure. Then holes were created from the outermost layers to the connector areas of the third and fourth layers and of the fifth and sixth layer with the 80-micrometer in diameter beam of YAG-laser applied from the both sides thereof.

The boards thus fabricated were processed through a Pd catalyst solution, electroless copper plating, and further electrical copper plating. Then dry-film photo-resist (produced by Asahi Chemical Industry Co., Ltd., model AQ-2588) was laminated, and circuits were formed through exposure, development, and etching, to finally obtain 220 mm-wide, 220 mm-long, 0.6 mm-thick 8-layer printed circuit bare boards .

A heat cycle test was performed at -65°C to 125°C for 1000 cycles with these multi-layer printed circuit bare boards, and no defects were found such as delamination or crack.

Moreover, it was verified that the wiring density with those multi-layer printed circuit bare boards was approximately four times as high as that of the conventional through hole printed boards. That confirmed that a higher interconnection density of the packaging is possible.

It was also verified that the process steps were fewer by a factor of 18 than those of the conventional built-up multi-layer printed circuit bare board with the same number of layers.

In summary, as described above, with the multi-layer printed circuit bare board having 4n layers stacked up, holes are machined through the insulation material layers that lay between the first and second layers, between the third and fourth layers, between the 4n-th and (4n-1)-th layers, and between the (4n-2)-th and (4n-3)-th layers, and filled with copper plating, thus establishing electrical interconnections between the first and second layers, between the third and fourth layers, between the 4n-th and (4n-1)-th layers, and between the (4n-2)-th and (4n-3)-th layers.

Making holes from the first layer to the copper-filled vias on the third layer and from the 4n-th layer to the copper-filled vias on the (4n-2)-th layer, and plating these holes make connections between the first and fourth layers and between the 4n-th and (4n-3)-th layers, such that interconnections through the laminated multi-layer structures between the intended layers are established with fewer manufacturing process steps. As a result, with this multi-layer printed circuit bare board, it is possible to increase the wiring density at lower manufacturing cost than that of the conventional built-up multi-layer printed circuit bare boards.

In accordance with the manufacturing process for the multi-layer printed circuit bare board of the invention, holes are formed through the insulation material between the conductive layers, and filled with copper plating, and the resultant multi-layer structures are laminated, that consist of the first and second layers, the third and fourth layers, the 4n-th and (4n-1)-th layers, and the (4n-2)-th and (4n-3)-th layers, respectively, using insulation bonding material. Holes are cut from the first layer to the third layer and from the 4n-th layer to the (4n-2)-th layer, and electrically plated with copper. This enables direct connections between the intended layers by the via holes made after lamination, and achieves connections between the first layer and the fourth layer, and between the 4n-th layer and the (4n-3)-th layer with fewer process steps and higher dimensional accuracy than the conventional built-up method in which the multi-layer structure is formed layer by layer by repeating similar process steps.

While the present invention has been described with reference to the particular illustrative embodiment, it is not to be restricted by the embodiment. It is to be appreciated that those skilled in the art can change or modify the embodiment without departing from the scope of the present invention.

## Claims

1. A multi-layer printed circuit bare board comprising:
at least two insulative layers (35) each having two flat, primary surfaces;
circuit layers (3, 5, 9, 13, 29, 25, 21, 19) including electrically conductive material (7, 15, 23, 27, 31, 39) forming electric circuitry (69) and carried on at least one of the primary surfaces of said insulative layers (35); and
bonding layers(45) of insulative material intervening between adjacent ones of said insulative layers and bonding said adjacent insulative layers with each other to accumulate said circuit layers with one above the other;
wherein at least a first of said at least two insulative layers (35) having a first through hole (37) open to the primary surfaces thereof and filled with electrically conductive material (15) interconnecting the circuit layers (9, 13) carried thereon with each other, and a second one of said at least two insulative layers (35) and one of said bonding layers (45) which is bonded to said second insulative layers (35) have a second through hole (41, 65) cut therethrough to extend to the primary surface of the first one of said at least two insulative layers (35) which is also bonded to said one bonding layer (45), said second through hole (41, 65) being filled with electrically conductive material (39) interconnecting the circuit layers (3, 9) carried on said first and second insulative layers (35) with each other, and
wherein the first and second through holes are not part of a through hole open to both sides of the bare board,
**characterized in that** said second through hole (41) extends from said second insulative layer (35) through said one of said bonding layers (45) to said electrically conductive material (15) filling the first through hole.

2. The bare board in accordance with claim 1,
**characterized in that** said electrically conductive material (39) is of copper plating.

3. The bare board in accordance with claim 1 or claim 2,
**characterized in that** said first through hole (37)has a circular cross section perpendicular to a longitudinal axis thereof.

4. The bare board in accordance with claim 1 or claim 2,
**characterized in that** said first through hole (37) has a oval or elliptical cross section perpendicular to a longitudinal axis thereof (FIGS. 2A, 2B).

5. The bare board in accordance with any one of claims 1 to 4,
**characterized in that** said first through hole (37) has a width of 40 micro-meters or less.

6. The bare board in accordance with any one of claims 1 to 5,
**characterized in that** said second through hole (41, 65) has a circular cross section perpendicular to a longitudinal axis thereof (FIGS. 2A, 2B).

7. The bare board in accordance with claim 6,
**characterized in that** said second through hole (41, 65) has a diameter of 40 micro-meters or less.

8. The bare board in accordance with any one of claims 1 to 5,
**characterized in that** said second through hole (41, 65) has a oval or elliptical cross section perpendicular to a longitudinal axis thereof.

9. The bare board according to any one of claims 1 to 8, comprising:
2n of said circuit layers (3, 5, 9, 29, 25, 21, 19), where n is a natural number exceeding two;
n of said insulative layer (35) each having two primary surfaces on which the (2i-1)-th and 2i-th ones of said circuit layers are carried, where I is a natural number not exceeding n; and
n-1 of said bonding layers (45) of insulative material intervening between adjacent ones of said n insulative layers (35);
wherein the insulative layers (35) between the (2i-1)-th and 2i-th circuit layers (3, 5) having said first through hole (37) filled with said electrically conductive material (7, 15, 39) interconnecting the (2i-1)-th and 2i-th circuit layers (3, 5) with each other.

10. The bare board in accordance with claim 9,
**characterized in that** the insulative layers (35) between the (2i-1)-the and 2i-th circuit layers (3, 5) further have a second through hole (41, 65) open to the primary surfaces thereof, said second through hole (41, 65) being filled with electrically conductive material 839) interconnecting the (2i-1)-the and (2i + 1)-th circuit layers (3, 9) with each other.

11. A method of manufacturing a multi-layer printed circuit bare board, comprising the step of preparing n sheets of insulative material (35), where n is a natural number exceeding a unity; **characterized by** further comprising the steps, in the indicated order, of:
making first holes (37) through the sheets of insulative material (35) for interconnecting (2i-1)-th and 2i-th circuit layers (3, 5) to be respectively carried on two primary surfaces of the sheets of insulative material (35), where I is a natural number not exceeding n;
depositing electrically conductive material (39) inside the first holes (37) using an electrical plating process until the holes (37) are filled with the conductive material (39);
forming an electrically conductive pattern of the (2i-1)-th and 2i-th circuits (69) on the sheet of insulative material (35);
stacking the sheets of insulative material (35) having the electrically conductive pattern (69) formed one above the other and adhering adjacent ones of the sheets (35) with each other by using bonding material (45);
making second holes (41, 65) through (2i-1)-th and (2i + 1)-th circuit layers (3, 9); and
depositing electrically conductive material (39) inside the second holes (41, 65) using an electrical plating process.

12. The method in accordance with claim 11,
**characterized in that** in the step of making the second holes (41, 65) said second holes (41, 65) are cut into the bonding material (45) to extend to the electrically conductive material (15) filling the first hole (37).

## Patentansprüche

1. Mehrschichtige unbestückte gedruckte Schaltungsplatine, umfassend:
wenigstens zwei Isolierschichten (35), die je zwei flache, primäre Oberflächen aufweisen;
elektrisch leitfähiges Material (7, 15, 23, 27, 31, 39) beinhaltende Schaltungsschichten (3, 5, 9, 13, 29, 25, 21, 19), die eine elektrische Schaltungsanordnung bilden (69) und auf wenigstens einer der primären Oberflächen der Isolierschichten (35) gehaltert sind; und
Isoliermaterialbondschichten (45), die sich zwischen benachbarten der Isolierschichten befinden und diese miteinander verbinden, um die Schaltungsschichten eine über der anderen anzuordnen;
wobei wenigstens eine erste der wenigstens zwei Isolierschichten (35) versehen ist mit einem ersten Durchgangsloch (37), das zu deren primären Oberflächen offen und gefüllt ist mit elektrisch leitfähigem Material (15), das die darauf gehalterten Schaltungsschichten (9, 13) miteinander verbindet, und eine zweite der wenigstens zwei Isolierschichten (35) und eine der besagten, mit den zweiten Isolierschichten (35) verbundene Bondschicht (45) versehen sind mit einem hierdurch hindurchgeschnittenen zweiten Durchgangsloch (41, 65), das sich erstreckt zur primären Oberfläche der ersten der wenigstens zwei Isolierschichten 83), die auch an die besagte eine Bondschicht (45) gebunden ist, wobei das zweite Durchgangsloch (41, 65) gefüllt ist mit elektrisch leitfähigem Material (39), das die Schaltungsschichten (3, 9), die auf der ersten und zweiten Isolierschicht (35) gehaltert sind, miteinander verbindet, und
wobei das erste und zweite Durchgangsloch nicht Bestandteil sind eines zu beiden Seiten der unbestückten Schaltungsplatine offenen Durchgangslochs,
**dadurch gekennzeichnet, dass** das zweite Durchgangsloch (41) von der zweiten Isolierschicht (35) durch die eine der besagten Bondschichten (45) zu dem das erste Durchgangsloch füllenden elektrisch leitfähigen Material (15) verläuft.

2. Platine nach Anspruch 1,
**dadurch gekennzeichnet, dass** das elektrisch leitfähige Material (39) als Kupferplattierung vorliegt.

3. Platine nach Anspruch 1 oder 2,
**dadurch gekennzeichnet, dass** das erste Durchgangsloch (37) einen kreisförmigen Querschnitt senkrecht zu seiner Längsachse aufweist.

4. Platine nach Anspruch 1 oder 2,
**dadurch gekennzeichnet, dass** das erste Durchgangsloch (37) einen ovalen oder elliptischen Querschnitt senkrecht zu seiner Längsachse aufweist (Figuren 2A, 2B).

5. Platine nach einem der Ansprüche 1 bis 4,
**dadurch gekennzeichnet, dass** das erste Durchgangsloch (37) eine Breite von 40 Mikrometer oder weniger aufweist.

6. Platine nach einem der Ansprüche 1 bis 5,
**dadurch gekennzeichnet, dass** das zweite Durchgangsloch (41, 65) einen kreisförmigen Querschnitt senkrecht zu seiner Längsachse aufweist (Figuren 2A, 2B).

7. Platine nach Anspruch 6,
**dadurch gekennzeichnet, dass** das zweite Durchgangsloch (41, 65) einen Durchmesser von 40 Mikrometer oder weniger aufweist.

8. Platine nach einem der Ansprüche 1 bis 5,
**dadurch gekennzeichnet, dass** das zweite Durchgangsloch (41, 65) einen ovalen oder elliptischen Querschnitt senkrecht zu seiner Längsachse aufweist.

9. Platine nach einem der Ansprüche 1 bis 8, umfassend:
2n Schaltungsschichten (3, 5, 9, 29, 25, 21, 19), wobei n eine natürliche Zahl größer als Zwei ist;
n Isolierschichten (35) mit je zwei primären Oberflächen, auf der die (2i-1)-te und 2i-te der Schaltungsschichten gehaltert sind, wobei i eine natürliche Zahl nicht größer als n ist; und
n-1 Isoliermaterialbondschichten (45), die sich zwischen benachbarten der n Isolierschichten (35) befinden;
wobei die Isolierschichten (35) zwischen den (2i-1)-ten und 2i-ten Schaltungsschichten (3, 5) versehen sind mit dem ersten Durchgangsloch (37), das gefüllt ist mit dem die (2i-1)-ten und 2i-ten Schaltungsschichten (3, 5) miteinander verbindenden elektrisch leitfähigen Material (7, 15, 39).

10. Platine nach Anspruch 9,
**dadurch gekennzeichnet, dass** die Isolierschichten (35) zwischen den (2i-1)-ten und 2i-ten Schaltungsschichten (3, 5) weiter ein zweites Durchgangsloch (41, 65) aufweisen, das zu deren primären Oberflächen offen ist, wobei das zweite Durchgangsloch (41, 65) mit elektrisch leitfähigem Material (39) gefüllt ist, das die (2i-1)-ten und (2i + 1)-ten Schaltungsschichten (3, 9) miteinander verbindet.

11. Verfahren zum Herstellen einer mehrschichtigen unbestückten gedruckten Schaltungsplatine,
umfassend den Schritt zum Herstellen von n Isoliermaterialblätter (35), wobei n eine natürliche Zahl größer als Eins ist; **dadurch gekennzeichnet, dass** das Verfahren weiter die Schritte in der angegebenen Reihenfolge umfasst:
Erzeugen erster Löcher (37) durch die Isoliermaterialblätter (35) zum Verbinden von (2i-1)-ten und 2i-ten Schaltungsschichten (3, 5), die je auf zwei primären Oberflächen der Isoliermaterialblätter (35) gehaltert werden sollen, wobei i eine natürliche Zahl nicht größer als n ist;
Abscheiden elektrisch leitfähigen Materials (39) in den ersten Löchern (37) unter Verwendung eines elektrischen Plattierungsverfahrens, bis die Löcher (37) mit dem leitfähigen Material (39) gefüllt sind;
Erzeugen eines elektrisch leitfähigen Musters aus den (2i-1)-ten und 2i-ten Schaltungen (69) auf dem Isoliermaterialblatt (35);
Übereinander Anordnen der mit dem elektrisch leitfähigen Muster (69) versehenen Isoliermaterialblätter (35);
Stapeln benachbarter Blätter (35) übereinander unter Verwendung von Bondmaterial (45);
Erzeugen zweiter Löcher (41, 65) durch (2i-1)-te und (2i + 1)-te Schaltungsschichten (3, 9); und
Abscheiden elektrisch leitfähigen Materials (39) in den zweiten Löchern (41, 65) unter Verwendung eines elektrischen Plattierungsverfahrens.

12. Verfahren nach Anspruch 11,
**dadurch gekennzeichnet, dass** im Erzeugungsschritt der zweiten Löcher (41, 65) diese in das Bondmaterial (45) geschnitten werden, um sich zu dem das erste Loch (37) füllenden, elektrisch leitfähigen Material (15) zu erstrecken.

## Revendications

1. Carte nue de circuit imprimé multicouche comprenant :
au moins deux couches isolantes (35) ayant chacune deux surfaces primaires, plates ;
des couches de circuits (3, 5, 9, 13, 29, 25, 21, 19) comprenant un matériau électriquement conducteur (7, 15, 23, 27, 31, 39) formant un ensemble de circuits électriques (69) et se trouvant sur au moins une des surfaces primaires desdites couches isolantes (35); et
des couches de liaison (45) de matériau isolant qui sont interposées entre les couches isolantes contiguës parmi lesdites couches isolantes et liant lesdites couches isolantes contiguës les unes avec les autres, pour accumuler lesdites couches de circuits les unes sur les autres ;
dans laquelle au moins une première desdites au moins deux couches isolantes (35) ayant un premier trou d'insertion (37) ouvert vers les surfaces primaires de celles-ci et rempli d'un matériau électriquement conducteur (15) interconnectant les couches de circuits (9, 13) qui se trouvent sur celles-ci, et une deuxième desdites au moins deux couches isolantes (35) et l'une desdites couches de liaison (45), qui est reliée auxdites deuxièmes couches isolantes (35), ont un deuxième trou d'insertion (41, 65) découpé dans celles-ci pour s'étendre jusqu'à la surface primaire de la première desdites au moins deux couches isolantes (35), qui est également reliée à ladite une couche de liaison (45), ledit deuxième trou d'insertion (41, 65) étant rempli d'un matériau électriquement conducteur (39) interconnectant les unes aux autres les couches de circuits (3, 9) qui se trouvent sur lesdites première et deuxième couches isolantes (35), et
dans laquelle les premier et deuxième trous d'insertion ne font pas partie d'un trou d'insertion ouvert vers les deux côtés de la carte nue,
**caractérisée en ce que** ledit deuxième trou d'insertion (41) s'étend à partir de ladite deuxième couche isolante (35) à travers une desdites couches de liaison (45) jusqu'audit matériau électriquement conducteur (15) remplissant le premier trou d'insertion.

2. Carte nue selon la revendication 1, **caractérisée en ce que** ledit matériau électriquement conducteur (39) est fait d'un dépôt de cuivre.

3. Carte nue selon la revendication 1 ou la revendication 2, **caractérisée en ce que** ledit premier trou d'insertion (37) a une coupe transversale circulaire perpendiculaire à un axe longitudinal de celle-ci.

4. Carte nue selon la revendication 1 ou la revendication 2, **caractérisée en ce que** ledit premier trou d'insertion (37) a une coupe transversale ovale ou elliptique, perpendiculaire à un axe longitudinal de celle-ci (figures 2A, 2B).

5. Carte nue selon l'une quelconque des revendications 1 à 4, **caractérisée en ce que** ledit premier trou d'insertion (37) a une largeur de 40 micromètres ou moins.

6. Carte nue selon l'une quelconque des revendications 1 à 5, **caractérisée en ce que** ledit deuxième trou d'insertion (41, 65) a une coupe transversale circulaire perpendiculaire à un axe longitudinal de celle-ci (figures 2A, 2B).

7. Carte nue selon la revendication 6, **caractérisée en ce que** ledit deuxième trou d'insertion (41, 65) a un diamètre de 40 micromètres ou moins.

8. Carte nue selon l'une quelconque des revendications 1 à 5, **caractérisée en ce que** ledit deuxième trou d'insertion (41, 65) a une coupe transversale ovale ou elliptique, perpendiculaire à un axe longitudinal de celle-ci.

9. Carte nue selon l'une quelconque des revendications 1 à 8, comprenant :
2n desdites couches de circuits (3, 5, 9, 29, 25, 21, 19), où n est un entier naturel supérieur à deux ;
n desdites couches isolantes (35) ayant chacune deux surfaces primaires sur lesquelles la (2i-1)ème couche de circuit et la 2i ème couche de circuit desdites couches de circuits se trouvent, où i est un entier naturel qui n'est pas supérieur à n ; et
n-1 desdites couches de liaison (45) de matériau isolant qui sont interposées entre des couches isolantes contiguës parmi lesdites n couches isolantes (35) ;
dans laquelle les couches isolantes (35) entre les (2i-1)ème et 2i ème couches de circuits (3, 5) ayant ledit premier trou d'insertion (37) rempli dudit matériau électriquement conducteur (7, 15, 39) interconnectant les (2i-1) ème et 2i ème couches de circuits (3, 5) les unes aux autres.

10. Carte nue selon la revendication 9, **caractérisée en ce que** les couches isolantes (35) entre les (2i-1) ème et 2i ème couches de circuits (3, 5) ont en outre un deuxième trou d'insertion (41, 65) ouvert vers les surfaces primaires de celles-ci, ledit deuxième trou d'insertion (41, 65) étant rempli de matériau électriquement conducteur (39) interconnectant les (2i-1) ème et 2i ème couches de circuits (3, 9) les unes aux autres.

11. Procédé de fabrication d'une carte nue de circuit imprimé multicouche, comprenant l'étape consistant à préparer n feuilles de matériau isolant (35), où n est un entier naturel supérieur à une unité ; **caractérisé en ce qu'**il comprend en outre les étapes, dans l'ordre indiqué, consistant à :
réaliser des premiers trous (37) dans les feuilles de matériau isolant (35) pour interconnecter les (2i-1)ème et 2i ème couches de circuits (3, 5) devant se trouver respectivement sur deux surfaces primaires des feuilles de matériau isolant (35), où i est un entier naturel qui n'est pas supérieur à n ;
déposer le matériau électriquement conducteur (39) dans les premiers trous (37) en utilisant un procédé d'électrodéposition jusqu'à ce que les trous (37) soient remplis du matériau conducteur (39) ;
former un motif électriquement conducteur des (2i-1)ème et 2i ème circuits (69) sur la feuille de matériau isolant (35) ;
empiler les unes sur les autres les feuilles de matériau isolant (35) ayant le motif électriquement conducteur (69) formé et faire adhérer les unes aux autres les feuilles (35) adjacentes en utilisant un matériau liant (45) ;
réaliser des deuxièmes trous (41, 65) dans les (2i-1) ème et 2i+1 ème couches de circuits (3, 9) ; et
déposer un matériau électriquement conducteur (39) dans les deuxièmes trous (41, 65) en utilisant un procédé d'électrodéposition.

12. Procédé selon la revendication 11, **caractérisé en ce que**, dans l'étape de réalisation des deuxièmes trous (41, 65), lesdits deuxièmes trous (41, 65) sont découpés dans le matériau liant (45) pour s'étendre jusqu'au matériau électriquement conducteur (15) remplissant le premier trou (37).
